# EUROPEAN PATENT APPLICATION

(11) **EP 2 804 454 A1**
(43) Date of publication of application: **19.11.2014**
(21) Application number: 13460030.3
(22) Date of filing: 13.05.2013
(51) Int. Cl.: H05K 7/20

(54) **Electrical cabinet and module for an electrical cabinet**

(71) Applicant: TRUMPF Huettinger Sp. Z o. o., 05-220 Zielonka (PL)
(72) Inventor: Ozimek, Pawel, 00-712 Warsaw (PL); Siembida, Tomasz, 05-205 Michalow (PL); Seemann, Mark J., 15642 North Huntington, PA (US)
(74) Representative: Kohler Schmid Möbus

(57) **Abstract**

An electrical cabinet (1) is adapted to receive one or more modules (11-13) having at least one heat generating electrical component (32-34), the cabinet (1) including at least one fluid cooled heatsink (FCH) (3, 4, 5, 10), wherein the FCH (3, 4, 5, 10) has at least one planar heat exchange surface (31) arranged horizontally for exchanging heat with a heat exchange surface (38-40) of the module (11-13).

## Description

The invention relates to an electrical cabinet adapted to receive one or more modules and a module for such an electrical cabinet.

Electrical cabinets are often adapted to receive one or more modules. The modules have at least one heat generating electrical component. Often it is necessary to cool the electrical component. To that end the module can be provided with channels for a cooling fluid. However, if such a module has to be exchanged, the fluid channels have to disconnected. This is a time consuming process. Furthermore there is a risk of leakage of cooling fluid.

The object of the present invention is to provide an electrical cabinet and a module that allow quick replacing of a module without having to disconnect the cooling system.

This object is solved according to a first aspect of the invention by an electrical cabinet adapted to receive one or more modules having at least one heat generating electrical component, the cabinet including at least one fluid cooled heatsink (FCH), wherein the FCH has at least one planar heat exchange surface. This heat exchange surface of the FCH is arranged horizontally or arranged from one side of the cabinet to the other side of the cabinet for exchanging heat with a heat exchange surface of the module. In this case, the module does not need to have channels for cooling fluid. The fluid cooled heatsink is part of the electrical cabinet and does not have to be exchanged. Therefore, a module can be quickly replaced. There is no risk of leakage of cooling fluid. Preferably, the fluid cooled heatsink is a water cooled heatsink. Due to the FCH having a planar heat exchange surface, there is a large area provided for heat exchange, ensuring very good heat transfer from the module to the FCH. Using an FCH with a large planar heat exchange surface has the additional advantage that it can serve for mechanically stabilising the electrical cabinet. A good stabilization is accomplished when the FCH reach from one side of the cabinet to the other side. Furthermore, the FCH can attenuate and reduce electromagnetic interference between modules.

The planar heat exchange surface can be easily cleaned to ensure that there is no dust between the heat exchange surfaces which would reduce the heat transfer. Using an FCH with a large planar heat exchange surface has the additional advantage that there is no need for a surface increasing geometry using comb-shaped or meander-shaped heat transfer bodies which tends to trap dirt and are difficult to clean.

The FCH may extend to more than the half, in particular more than 70% of the plane width of the cabinet. In this way the FCH can attenuate and reduce electromagnetic interference between modules better.

A fluid or paste can be applied between the FCH and the heat transferring plates of the module in order to increase heat transfer efficiency. The fluid or paste can be silicone heat transfer compound. Various metal oxide ceramic powders could be implemented. The FCH may be designed that the amount of transferred heat may be more than 500W.

The amount of transferred heat can be up to 1500W per module.

The cabinet may comprise a guide system for guiding the module when inserting the module into the electrical cabinet, wherein the guide system comprises a horizontal guide part guiding the module horizontally at a spacing to the heat exchange surface of the FCH and a vertical guide part for guiding the module vertically into a position thermally contacting the FCH. Thus, the module can be inserted and taken out of the cabinet without touching the heat exchange surface of the FCH. Damage to the heat exchange surfaces can thus be prevented. The horizontal guide part and the vertical guide part of the guide system may be combined in one physical element. Vertical guidance may be along a slope, i.e. vertical and horizontal guidance may be superposed. In particular, the vertical guide part and the horizontal guide part may be part of a guide rail. The vertical guide part and the horizontal guide part may be one formed metal element. The cabinet may comprise two guide systems on one horizontal plane to guide one module. This means, the guide system can be provided on either side of a module.

The cabinet may comprise more than two guide systems on one horizontal plane in order to guide more than one module. Furthermore, the one guide system may be designed to guide more than one module. When being inserted, the module may be guided vertically a shorter distance compared to the distance it is moved horizontally when it is inserted. Furthermore, the guide system may be designed such that the module can be guided horizontally after it has been guided vertically. This last distance of guidance can be sufficient to connect the module electrically to the socket in the electrical cabinet.

The electrical cabinet according to the invention has the advantage, that modules can be exchanged without having to turn off the other modules in the cabinet. Thus, exchange of a module can be realized extremely quickly.

The FCH may comprise an upper and a lower heat exchange surface. In this case, the FCH can be used to cool at least two modules, one provided on top of the FCH and one provided below the FCH.

The length and width of the FCH may correspond to the length and width of the cabinet. Thus, the area of the FCH approximately corresponds to the area covered by the cabinet. In this way the heat exchange surface can be maximised. Also, the FCH may serve to stabilize the cabinet.

At least one clamping element may be provided for clamping the module in thermal contact with the FCH. Thus it can be ensured that the module stays in contact with the FCH while inserted in the electrical cabinet.

The clamping element may also ensure an electrical contact between the module and the FCH. This may be important for good electromagnetical behavior as it is explained later.

The at least one clamping element may be implemented in or at the guide system in particular in the region if the vertical guide part for pressing the module vertically in a position thermally contacting the FCH.

The clamping element may include a spring element. Thus, clamping occurs automatically when the module is in the correct position for heat transfer with the FCH.

The heat exchange surface may be surface treated for reduced roughness below 2 µm and waviness below 2 µm. Roughness may be even lower than 1 µm. Actually values about 0.63 µm are most favorable. Waviness may be even lower than 1 µm. Actual values about 0.8 µm are most favorable: Flatness may be lower than 0.2 mm or even lower than 0.05 mm. In particular, the heat exchange surface may be polished.

The heat exchange surface may be coated with a material which is resistant to abrasion. Appropriate materials may be: aluminum, copper, and stainless steel. As coating materials are possible nickel, silver, and tin for example.

The electrical cabinet may be provided with an interlock system and locking elements for locking the module in position in the cabinet may interact with the interlock system. An interlock system is a safety precaution which may be implemented by fitting one or a plurality of contacts to doors, flaps, or similar openings of the electrical cabinet and/or of the modules. If such a contact is opened, for example by a door being opened, the current feed of one or all modules or other equipment in the electrical cabinet may be interrupted. It is thus ensured in a simple manner that no voltage is present in or at the system if, for example, maintenance work or the like is to be carried out.

Bulkhead power and control or data communication connectors may be provided at the end of a module slot. Thus, by inserting a module, the module is automatically connected in terms of power and data communication. The power connectors may be arranged to guide currents above 10 A, voltages above 100 V or power above 1000 W. The data communication may be of one or several of the art: analog signals, binary signals and serial digital communication like CAN, RS232, RS485, Profi Bus, Ether Cat or Device Net. Moreover a special type of connector can be used: providing at least one or few shorter pins than others pin especially the power pins, which can be used in the interlock loop in order to disconnect the power from the power pins during pulling out the unit before the power and/or current pins begin to disconnect. Thus electric arc or sparks are avoided once powered and loaded unit is pulling out. Guidance effect may be achieved during inserting the unit into its slot.

An internal air circulation in the cabinet can be used in order to cool down additional components in the cabinet that are not directly attached to the FCH. Fins or other surface enlarging means in the module may be attached to the FCH inside the cabinet to cool down the air inside the cabinet and transport the heat from the air inside the cabinet to the FCH. A heat exchanger may installed inside the cabinet to transport the heat from the air inside the cabinet to the fluid. This could also be used as a dehumidifier in order to avoid water condensation on components inside the cabinet. The internal air circulation may be a forced air circulation in particular with the help of a fan.

According to a second aspect the invention relates to a module having at least one heat generating electrical component mounted on a heat transfer plate, wherein the heat transfer plate has a planar heat exchange surface preferably arranged horizontally and being the upper or lower surface of the module for exchanging heat with the heat exchange surface of an FCH of an electrical cabinet. Thus, a module is provided with a large surface for heat exchange with an FCH. It is therefore not necessary to implement a fluid cooling system in or on the module. Furthermore, a planar heat exchange surface can be made relatively easily. Compared to more complex heat exchange structures, a planar heat exchange surface is very simple, easy to clean, easy to maintain and suitable for ensuring a large heat transfer area.

The module may comprise the counterpart of a guide system for guiding the module when inserting it into the electrical cabinet. For example, the module may comprise studs or bearings which cooperate with the guide rail provided in the electrical cabinet.

It is also possible that the modules comprise the guide system and the cabinet comprises the counterpart of a guide system.

The clamping element for clamping the module (11-13) in thermal contact with the FCH may also be arranged at the module.

The heat exchange surface may be surface treated to reduce roughness and waviness. For example, the heat exchange surface may be polished and/or coated with material enhancing heat exchange properties. A particular good heat transfer can be achieved if the heat transfer plate is made of an aluminum alloy.

The heat exchange surface may be surface treated for reduced roughness below 2 µm and waviness below 2 µm. Roughness may be even lower than 1 µm. Actually values about 0.63 µm are most favorable. Waviness may be even lower than 1 µm. Actual values about 0.8 µm are most favorable: Flatness may be lower than 0.2 mm or even lower than 0.05 mm. In particular, the heat exchange surface may be polished. I may be coated with a material which is resistant to abrasion. Appropriate materials may be: aluminum, copper, and stainless steel. As coating materials are possible nickel, silver, and tin for example. Both connected materials may have the same material surface in order to avoid corrosion and bad electrical connection.

The module may comprise an eject element for facilitating the removal of the module from the cabinet, for example, an additional screw may be provided at the front of the module to allow ejection of the module if necessary without the use of force.

An internal air circulation in the module can be used in order to cool down the components in the module that are not directly attached to the heat transfer plate of the module. Fins or other surface enlarging means in the module may be attached to the heat transfer plate inside the modules to cool down the air inside the modules and transport the heat from the air inside the module to the heat transfer plate. The internal air circulation may be a forced air circulation in particular with the help of a fan.

The module may be designed that the amount of transferred heat may be more than 500W. The amount of transferred heat can be up to 1500W per module.

The invention also relates to a cooling system comprising an inventive electrical cabinet and at least one inventive module inserted into the electrical cabinet. Cabinets with FCH having such a planar heat exchange surface are very flexible for inserting modules of very different width. Different rack units in height are also possible.

The FCH and the guide system may be provided in the cooling system in a way such that one FCH can be used for heat exchange with more than one module. For example, one module can be arranged on top of the FCH and one module can be provided below the FCH, each module contacting the FCH to transfer heat. In the alternative, two or more modules may be provided next to one another and all touch the FCH on the same side.

The modules can be power supply units. The cabinet can be a power supply system for such power supply units. The cooling system may be such a power supply system. Such power supply systems transform very high power over 10 kW. Such power supply systems are often used to transform current or voltage for plasma processes, induction or resistive heating or for network supply. A plurality of power supply units work in parallel for distributing the high power levels. When one power supply detects a fault inside itself, then this power supply may switch off itself and show its status at a display or light emitting device on the front of the power module or send a status-signal to a master control. The module may be replaced very quickly by a new one and the whole system is restartable very quickly without the need of de-aerate the fluid cooling system. Even a replacement without switching off the whole power supply system a so called "hot-plug" is possible.

In the modules may be transistors arranged such as IGBTs or MOSFETs. These transistors are designed to fast switching high currents over 10 A and high voltages over 100 V in less than 100 ns. Such fast switching of high voltages and currents produce extremely high electromagnetical radiance. This radiance may be extremely disturbing to data communication even to digital data communication. But such a fast switching is needed for power conversion with high effectivity such as power conversion with effectivities over 75%. It could be shown that for such rates of effectivity and for such fast switching of high current and voltage the above mentioned FCH with their geometrical structure in the cabinet have an extremely good electromagnetical damping behavior which enables the modules to operate in the cabinet without mutual disturbance. Using the FCHs with the large planar heat exchange surface contacting the modules also with a large planar heat exchange surface enables an extremely good electrical connection of the module with the FCH.

The invention also relates to a method for mounting more than one module into an electrical cabinet, the cabinet including at least one fluid cooled heatsink (FCH), wherein the FCH has at least one planar heat exchange surface arranged for exchanging heat with the heat exchange surface of the module, the module having at least one heat generating electrical component mounted on a heat transfer plate, wherein the heat transfer plate has a planar heat exchange surface, the method comprising the steps:
a moving the modules for a first distance in the direction of a planar heat exchange surface of the FCH along a guide system into the cabinet without touching the FCH and with a spacing to the FCH,
b moving the modules for a second shorter distance in the direction of the planar heat exchange surface of the FCH along a guide system into the cabinet with a smaller spacing to the FCH as along the first distance. The shorter distance can be used for inserting connectors into sockets.

In step a. the spacing may be more than 0.2 mm.

Furthermore, the modules can pressed onto the FCH during a third distance which is shorter than the first distance and in particular shorter than the second distance.

The invention is described by way of example with reference to the accompanying drawings, wherein:
FIG. 1 shows a very schematic representation of an electrical cabinet;
FIG. 2 in a first perspective view three modules to be arranged on a fluid cooled heatsink;
FIG. 3 a different perspective view of three modules to be arranged on an FCH;
FIG 4 a more detailed view of modules and an FCH;
FIG. 5a - different part views of a module and a guide system showing FIG. 5d the insertion of a module into the cabinet;
FIG. 6 a perspective part view of modules being arranged in the cabinet and locked into position.

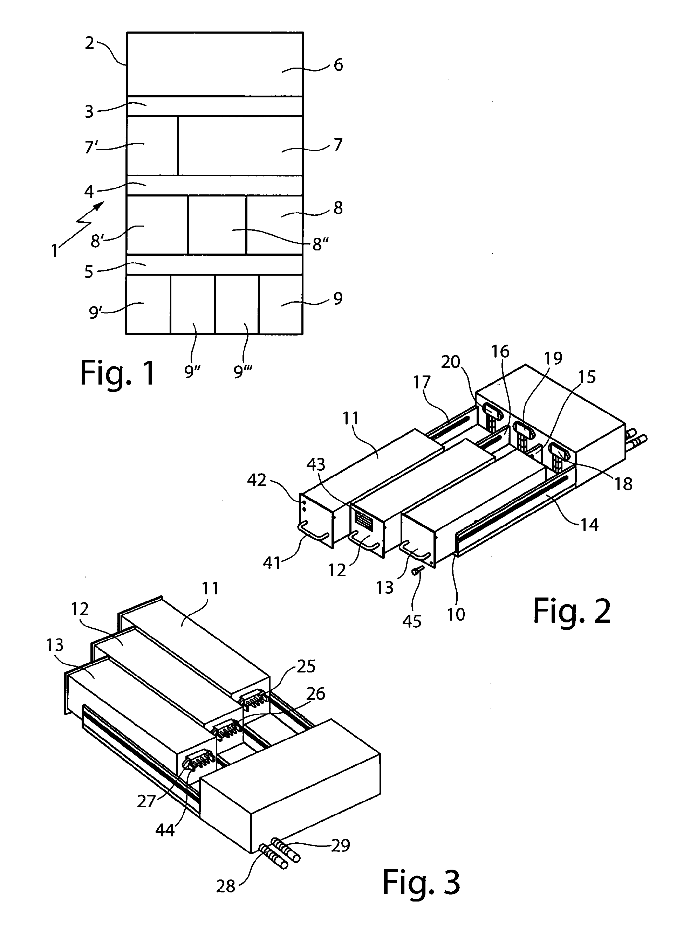

FIG. 1 shows a very schematic front view of an electrical cabinet 1, having a frame 2 and fluid cooled heatsinks (FCH) 3-5 arranged in a horizontal fashion. In particular, the FCHs 3-5 have a horizontal, planar surface on the top and the bottom. Modules can be arranged in receptacles 6-9 and contact the FCHs 3-5 in order to transfer heat from the modules to the FCHs 3-5. Thus, optimal heat transfer from the modules to the FCHs 3-5 can be provided for without having to have separate cooling circuits on or in the modules themselves. In particular, one module can be taken out and replaced by another module without having to shut down the other modules and without having to disconnect any of the cooling fluid lines. The cooling fluid has typically temperatures between 5 °C and 50 °C and a flow velocity up to 12 1/min, and a pressure of maximum 10 bar, and a differential pressure above 1 bar. A plurality of receptacles 7, 7'; 8, 8', 8"; or 9, 9' , 9" , 9"' can be arranged in one plane. A fluid distributor (not shown) may be arranged inside or outside the cabinet. A flow control unit may regulate the flow through the FCHs. Temperature measuring devices may be placed at the FCHs.

FIG. 2 shows a perspective view of an FCH 10, on which three modules 11, 12, 13 are to be arranged. When inserting the modules 11, 12, 13, the modules 11, 12, 13 are guided by a guiding system which has in the embodiment shown four guide rails 14 to 17. As can be seen the guide rails 15 and 16 are used to guide two modules 11, 12, 13 each. At the end of the FCH 10 sockets 18, 19, 20 are provided for connecting the modules 11 to 13 to power and signal lines. An eject element 45 for facilitating the removal of the module from the cabinet, for example, an additional screw may be provided at the front of the module to allow ejection of the module if necessary without the use of force. A clamp 41 is arranged at the front of the modules further facilitating the removal of the modules. A display 43 or a light emitting device 42 on the front of the module may show the status of the module. The modules may be locked with locking elements like screws with similar geometry like the eject element 45. The electrical cabinet may be provided with an interlock system and the locking elements for locking the module in position in the cabinet may interact with the interlock system.

FIG. 3 shows a different perspective view of the arrangement shown in FIG. 2. Therefore, the same reference numerals are being used. It can be seen that modules 11 to 13 have bulkhead connectors 25 to 27 for connecting to the sockets 18 - 20. A guidance system 44 which corresponds to the connector and plug is arranged bulkhead. Furthermore, it can be seen that a cooling fluid inlet 28 and a cooling fluid outlet 29 are provided.

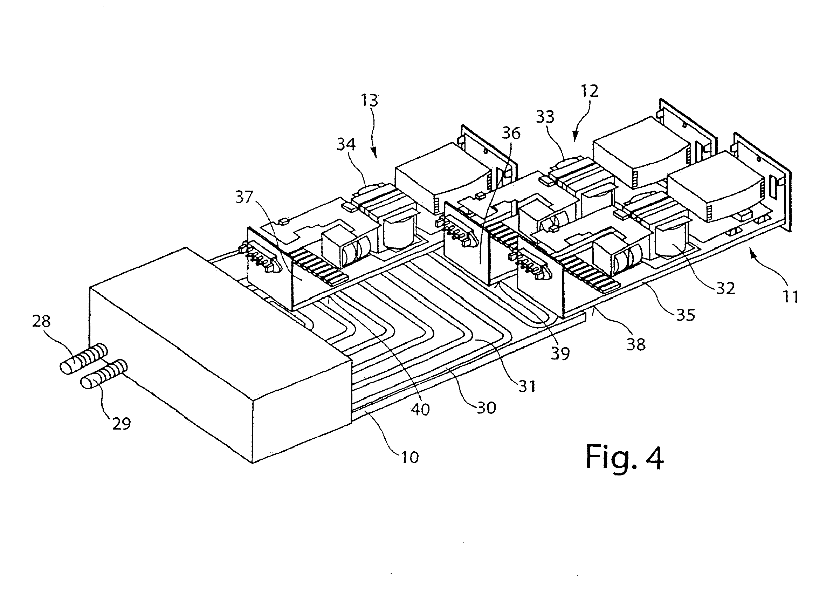

FIG. 4 shows a more detailed perspective view of the FCH 10 and the modules 11 - 13. The FCH 10 is provided with cooling fluid channels 30 which provide cooling of the FCH. The channels 30 are connected to the cooling fluid inlet 28 and the cooling fluid outlet 29. The FCH 10 is provided with a planar heat exchange surface 31.

The modules 11, 12, 13 have numerous electrical, heat generating components, only one for each module 11 - 13 carries a reference numeral 32 - 34. The heat generating components 32 - 34 are arranged on top of a heat transfer plate 35, 36, 37. Heat generating components may be one or more of the following: transformers, combiner, transistor, impedance matching components, capacitors, inductivities. A fluid or paste can be applied between the heat generating components 32 - 34 and the heat transferring plates 35, 36, 37 in order to increase heat transfer efficiency. The fluid or paste can be silicone heat transfer compound. Various metal oxide ceramic powders could be implemented. The heat transfer plates 35, 36, 37 have a heat exchange surface 38, 39, 40, which in the embodiment shown is the lower surface of the modules 11, 12, 13. The heat exchange surfaces 38, 39, 40 are extremely flat and planar. This ensures that when the modules 11, 12, 13 are inserted, i.e. provided on top of the heat exchange surface 31, there is no gap between the heat exchange surface 31 and the heat exchange surfaces 38, 39, 40. This ensures optimum heat transfer. To improve the heat transfer, the heat exchange surfaces 31, 38 - 40 may be surface treated in particular, polished or coated with a material enhancing heat transfer.

For clarity reasons the guide system is not shown in FIG. 4.

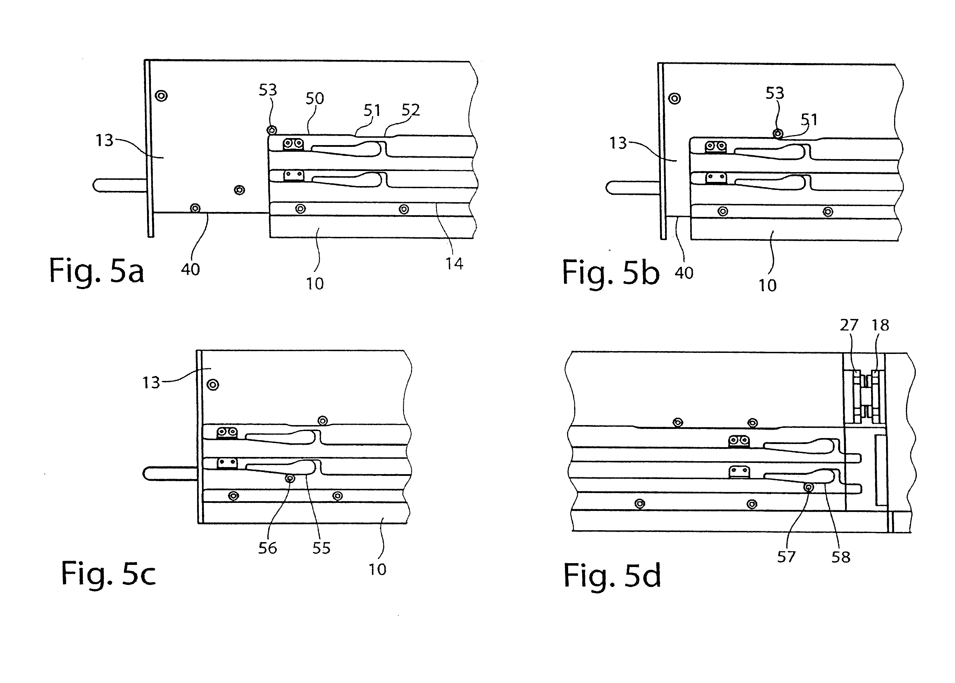

FIG. 5a shows the front part of a module 13 in a side view. It also shows the front part of guide rail 14. Guide rail 14 has a first horizontal guide part 50, a vertical guide part 51 and a second horizontal guide part 52. Basically, vertical guide part 51 and second horizontal guide part 52 form a depression in the guide rail 14. Module 13 has a counterpart of the guide system, namely a stud or bearing 53, which can be guided along horizontal guide part 50. In the situation shown, because bearing 53 rests on horizontal guide part 50, heat exchange surface 40 is provided at a small spacing from heat exchange surface 31 of the FCH 10. This means that module 13 can be inserted or moved relative to the FCH 10 without the heat exchange surfaces 40, 31 touching one another. Thus, scratches and damage to the heat exchange surfaces 40, 31 can be prevented.

As the module 13 is pushed further into the cabinet, bearing 53 travels along vertical guide part 51, which in the embodiment is a slope. This causes the module 13 to move downwards until heat exchange surface 40 comes into contact with heat exchange surface 31. This situation is shown in FIG. 5b.

As can be seen in FIG. 5c, further pushing of the module 13 causes the bearing 53 to travel along second horizontal guide part 52. By doing that, bulkhead connector 27 is plugged into socket 18, as can be seen in FIG. 5d. Furthermore, a clamping element 55, embodied as a curved spring, cooperates with the stud 56 provided on the module 13. In fact, stud 56 is pushed under clamping element 55 thereby deforming the clamping element 55. This interaction causes module 13 to be pressed downwards, i.e. into contact with the FCH 10. The same happens at the end of module 13, as can be seen in FIG. 5d. Here stud 57 engages clamping element 58, which is embodied in the same way as clamping element 55.

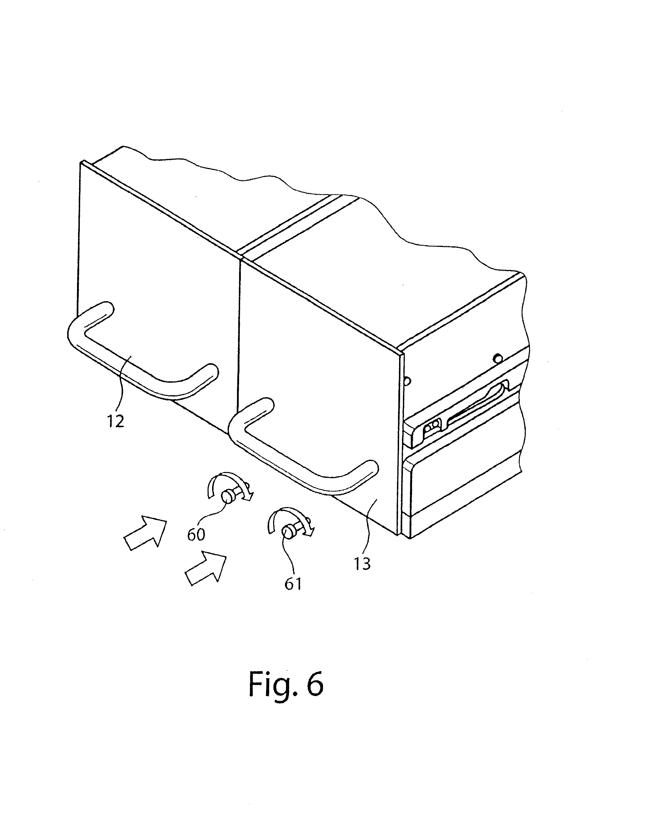

FIG. 6 shows a further perspective view of part of the two modules 12, 13 being inserted into a cabinet. Locking elements 60, 61, embodied as screws, can be inserted into the FCH 10 thus locking the modules 12, 13 in place. The locking elements 60, 61 can cooperate with an interlock system. In particular, if the locking elements 60, 61 are missing, electrical power to the modules 12, 13 may be interrupted.

## Claims

1. Electrical cabinet (1) adapted to receive one or more modules (11-13) having at least one heat generating electrical component (32-34), the cabinet (1) including at least one fluid cooled heatsink (FCH) (3, 4, 5, 10), wherein the FCH (3, 4, 5, 10) has at least one planar heat exchange surface (31) arranged horizontally or arranged from one side of the cabinet to the other side of the cabinet for exchanging heat with a heat exchange surface (38-40) of the module (11-13).

2. Electrical cabinet according to claim 1, wherein the cabinet (1) comprises a guide system for guiding the module (11-13) when inserted into the electrical cabinet (1), wherein the guide system comprises a horizontal guide part (50) guiding the module horizontally at a spacing to the heat exchange surface (31) of the FCH (3, 4, 5, 10) and a vertical guide part (51) for guiding the module (11-13) vertically into a position thermally contacting the FCH (3, 4, 5, 10).

3. Electrical cabinet according to any of the preceding claims, wherein at least one clamping element (55, 58) is provided for clamping the module (11-13) in thermal contact with the FCH (3-5, 10).

4. Electrical cabinet according to any of the preceding claims, wherein the heat exchange surface (31) of the FCH (3-5, 10) is surface treated for reduced roughness below 2µm and waviness below 2µm.

5. Electrical cabinet according to any of the preceding claims, wherein the FCH (3, 4, 5, 10) may extend to more than the half, in particular more than 70% of the plane width of the cabinet (1).

6. Electrical cabinet according to any of the preceding claims, wherein the FCH is designed that the amount of transferred heat may be more than 500W.

7. Electrical cabinet according to any of the preceding claims, wherein an interlock system is provided and locking elements (60, 61) for locking the module (11-13) in position in the cabinet (1) interact with the interlock system.

8. Electrical cabinet according to any of the preceding claims, wherein bulkhead current connectors designed for currents over 10A and voltages over 100 V and data communication connectors (18-20) are provided at the end of a module receptacle.

9. Module (11-13) having at least one heat generating electrical component (32-34) mounted on a heat transfer plate, wherein the heat transfer plate (35-37) has a planar heat exchange surface (38-40) arranged preferably horizontally and being the upper or lower surface of the module (11-13) for exchanging heat with a heat exchange surface (31) of an FCH (3-5, 10) of an electrical cabinet (1).

10. Module according to claim 9, wherein the module (11-13) comprises the counterpart of a guide system for guiding the module (11-13) when inserted into the electrical cabinet (1).

11. Module according to any of the claims 9 - 10, wherein the module (11-13) comprises an eject element (45) for facilitating the removal of the module (11-13) from the cabinet (1).

12. Cooling system comprising an electrical cabinet (1) according to any of the claims 1 - 8 and a module (11-13) according to any of the claims 9 - 11 inserted into the electrical cabinet.

13. Cooling system according to claim 12, where the FCH (3-5, 10) and the guide system are arranged that one FCH (3-5, 10) has possibility for heat exchange with more than one module (11-13).

14. Method for mounting more than one module (11-13) into an electrical cabinet (1), the cabinet (1) including at least one fluid cooled heatsink (FCH) (3-5, 10), wherein the FCH (3-5, 10) has at least one planar heat exchange surface (31) arranged for exchanging heat with a heat exchange surface (38-40) of the module (11-13),
the module (11-13) having at least one heat generating electrical component (32-34) mounted on a heat transfer plate (35-37), wherein the heat transfer plate (35-57) has a planar heat exchange surface (38-40), the method comprising the steps:
- moving the modules (11-13) for a first distance into direction of the planar heat exchange surface (31) of the FCH (3-5, 10) along a guide system into the cabinet without touching the FCH (3-5, 10) and with a spacing to the FCH (3-5, 10)
- moving the modules (11-13) for a second shorter distance into direction of the planar heat exchange surface (31) of the FCH (3-5, 10) along a guide system into the cabinet (1) with a smaller spacing to the FCH (3-5, 10) as along the first distance.

15. Method according to claim 14, wherein the modules (11-13) are pressed onto the FCH (3-5, 10) during a third distance which is shorter than the first distance and in particular shorter than the second distance.
